# EUROPÄISCHE PATENTSCHRIFT

(11) **EP 2 147 469 B1**
(45) Veröffentlichungstag und Bekanntmachung des Hinweises auf die Patenterteilung: **03.10.2012**
(21) Anmeldenummer: 08759507.0
(22) Anmeldetag: 09.05.2008
(51) Int. Cl.: H01L 41/083

(54) **PIEZOELEKTRISCHES VIELSCHICHTBAUELEMENT**
PIEZOELECTRIC MULTI-LAYER COMPONENT
COMPOSANT MULTICOUCHE PIÉZOÉLECTRIQUE

(30) Priorität: 11.05.2007 DE 102007022093
(43) Veröffentlichungstag der Anmeldung: 27.01.2010
(73) Patentinhaber: Epcos AG, 81669 München (DE)
(72) Erfinder: DÖLLGAST, Bernhard, A-8530 Deutschlandsberg (AT); GLAZUNOV, Alexander, A-8530 Deutschlandsberg (AT); DERNOVSEK, Oliver, A-8010 Graz (AT)
(74) Vertreter: Epping - Hermann - Fischer
(86) Internationale Anmeldenummer: PCT/EP2008/055783
(87) Internationale Veröffentlichungsnummer: WO 2008/138906

(56) Entgegenhaltungen:
- DE-A1- 10 201 641
- DE-A1-102005 052 686
- US-A1- 2004 222 719

## Beschreibung

Es wird ein piezoelektrisches Vielschichtbauelement angegeben, welches unter mechanischer Belastung einen kontrollierten Riss bildet.

Aus DE 10 2004 031 404 A1 ist ein piezoelektrisches Bauteil mit einem Aktorkörper bekannt, wobei der Aktorkörper eine Sollbruchstelle aufweist, die derart ausgestaltet ist, dass ein durch die Sollbruchstelle erlaubter Riss den Aktorkörper in zumindest zwei Teilstapel unterteilt. Weitere Beispiele sind bekannt aus DE 10 2005 052 686 A1 und DE 102 01 641 A1. Eine zu lösende Aufgabe besteht darin, ein piezoelektrisches Vielschichtbauelement anzugeben, welches bei dauerhafter mechanischer Belastung funktionstüchtig bleibt.

Es wird ein piezoelektrisches Vielschichtbauelement mit einem Stapel von abwechselnd übereinander angeordneten piezokeramischen Schichten und Elektrodenschichten angegeben, wobei benachbarte Schichten des Stapels unter gegenseitiger, in laterale Richtung geneigter mechanischer Spannung stehen. Die Schichten des Stapels sind dementsprechend gegeneinander verspannt, wobei die Spannungen bzw. die Spannkräfte senkrecht zur Stapelrichtung verlaufen.

Es ist Teil der Erfindung, dass die gegenseitige Verspannung zwischen benachbarten piezokeramischen Schichten vorhanden ist. Sie kann jedoch auch zwischen benachbarten piezokeramischen Schichten und Elektrodenschichten entstehen.

Mittels der mechanischen Spannung zwischen den benachbarten Schichten kann das Vielschichtbauelement unter bestimmten mechanischen Belastungen während seines Betriebs Risse bilden, die im Wesentlichen parallel zu den Schichten verlaufen. Mit anderen Worten kann der Stapel teilweise in lateraler Richtung geteilt werden oder er zerspringt in lateraler Richtung aufgrund der vorhandenen mechanischen Spannungen entlang zumindest einer Ebene zwischen den benachbarten Schichten. Wenn sich benachbarte Schichten voneinander lösen bzw. beginnen, sich voneinander zu lösen, rutschen sie in im Wesentlichen in lateraler Richtung voneinander weg.

Ein solches piezoelektrisches Vielschichtbauelement ist mit einer verminderten Gefahr behaftet, dass Risse bzw. Spalten unkontrolliert und senkrecht zu den Schichten verlaufen und somit beispielsweise Kurzschlüsse zwischen Elektrodenschichten des Vielschichtbauelements entstehen. Dadurch kann das Vielschichtbauelement über einen längeren Zeitraum unter Dauerbelastung funktionstüchtig bleiben.

Folgende bevorzugte Wege erlauben die gewünschte laterale mechanische Spannung zwischen benachbarten Schichten zu erreichen.

Gemäß einer Ausführungsform des Vielschichtbauelements weisen benachbarte Schichten des Stapels beispielsweise unterschiedliche Sinterschwundeigenschaften auf. Beim Versintern des Vielschichtbauelements entsteht aufgrund der unterschiedlichen Sinterschwundeigenschaften der Schichten die gewünschte mechanische Spannung zwischen den Schichten.

Gemäß einer Ausführungsform des piezoelektrischen Vielschichtbauelements weisen unterschiedliche Schichten des Stapels unterschiedliche Sinterschwundeigenschaften auf. Beispielsweise könnte eine erste Schicht einen höheren Sinterschwund bei einer ersten Temperatur aufweisen, als die benachbarte Schicht bei derselben Temperatur. Als Sinterschwund ist dabei die Änderung der Abmessungen einer Schicht im Verhältnis zum Zeitverlauf zu verstehen. Das bedeutet, dass innerhalb eines Zeitfensters bei einer bestimmten Temperatur, wobei das Zeitfenster sehr klein sein kann, eine Schicht sich mehr zusammenzieht, als eine andere Schicht. Wenn sich die Abmessungen einer Schicht durch den Sinterschwund verändern, kann es sich dabei um eine Volumenänderung der Schicht handeln.

Gemäß einer Ausführungsform des Vielschichtbauelements können benachbarte piezokeramische Schichten unterschiedliche Sinterschwundeigenschaften aufweisen. Auch können benachbarte Elektrodenschichten und piezokeramische Schichten untereinander verspannt sein, in dem beispielsweise die Elektrodenschichten neben einem elektrisch leitenden Elektrodenmaterial zusätzlich ein Material enthalten, welches unterschiedliche Sinterschwundeigenschaften aufweist, als die benachbarte piezokeramische Schicht. Dabei könnte es sich um ein keramisches, insbesondere um ein piezokeramisches Material handeln, wobei die Menge dieses Materials für jede Elektrodenschicht im Vergleich zum metallischen Material der Elektrodenschicht verhältnismäßig klein ist.

Vorzugsweise weisen die benachbarten Schichten unterschiedliche laterale Sinterschwundeigenschaften auf. Dabei ziehen sie sich während des Sintervorgangs lateral unterschiedlich zusammen. Eine Kombination aus vertikalen und lateralen Sinterschwundeigenschaften ermöglicht ebenfalls das Erreichen der gewünschten mechanischen Spannung.

Es wurde experimentell festgestellt, dass auch unterschiedliche Korngrößenverteilungen innerhalb der Schichten bzw. unterschiedliche Verteilungen der Größen der in den Schichten enthaltenen Körner den gewünschten Effekt unterstützen bzw. hervorrufen. Dabei handelt es sich um keramische Körner, wobei diese nicht nur in piezokeramischen Schichten enthalten sein können, sondern auch in Elektrodenschichten.

Gemäß einer Ausführungsform des piezoelektrischen Vielschichtbauelements weisen die Materialien benachbarter Schichten des Stapels verschiedene Kalzinationstemperaturen auf. Es wurde festgestellt, dass diese Eigenschaft das Erreichen der gewünschten mechanischen Spannung unterstützt. Es wurde insbesondere beobachtet, dass verschiedene Kalzinationstemperaturen der Materialien benachbarter Schichten deren jeweiligen Sinterschwund beeinflussen.

Die benachbarten Schichten enthalten gemäß einer Ausführungsform unterschiedliche Dotierstoffe, die das Erreichen der gewünschten mechanischen Spannung zwischen ihnen unterstützen. Es wurde insbesondere beobachtet, dass unterschiedliche Dotierstoffe ihre jeweiligen Sinterschwundeigenschaften beeinflussen. Darüber hinaus können benachbarte Schichten unterschiedliche Sinterhilfmittel enthalten. Beispielsweise könnte eine Schicht, die in der beschriebenen Art gegen eine benachbarte Schicht verspannt ist, als Sinterhilfmittel bzw. als Dotierung ein Material umfassend Pb0 oder Sn0 enthalten. Auch könnte die Schicht beispielsweise ein Material umfassend Pb0 oder SnO sowie beispielsweise SiO₂ bzw. eine erstarrbare Flüssigphase eines dieser Materialien bzw. Materialkombinationen enthalten.

Es wird außerdem ein Verfahren zur Herstellung eines piezoelektrischen Vielschichtbauelements angegeben, wobei unterschiedliche Keramikmischungen, welche vorzugsweise jeweils eine PZT Keramik enthalten, vorbereitet werden. Die Keramikmischungen werden mit Keramikkörnern unterschiedlicher Größen vorbereitet. Die Korngrößen bzw. die Durchmesser der Körner unterscheiden sich dabei untereinander vorzugsweise um das Mehrfache. Somit werden Keramikmischungen geschaffen, welche unterschiedliche Korngrößenverteilungen aufweisen.

Die Keramikmischungen können zur vereinfachten Formgebung in Folien organische Bindemittel enthalten, die später in einem Entbinderungsprozess entfernt werden können. Den Keramikmischungen können des Weiteren unterschiedliche Dotierstoffe bzw. Dotierstoffkonzentrationen beigemengt werden, wodurch die Sinterschwundeigenschaften der Keramikmischungen weiter beeinflussbar werden.

Die Keramikmischungen werden zu Grünfolien verarbeitet. Diese werden mit Elektrodenschichten bedruckt. Ein bevorzugtes Elektrodenmaterial ist Kupfer; Silber und Palladium bzw. eine Legierung wenigstens zwei dieser Materialien lässt sich als Elektrodenmaterial ebenfalls einsetzen. Die Grünfolien werden anschließend zurechtgeschnitten und übereinander gestapelt, sodass benachbarte Schichten des Stapels unterschiedliche Korngrößenverteilungen aufweisen.

Ein so angefertigtes, noch grünes Vielschichtbauelement wird anschließend entbindert, wobei in den Grünfolien noch vorhandenes Bindemittel verflüchtigt bzw. die Grünfolien entkohlt werden. Anschließend kann das Vielschichtbauelement zu einem monolithischen Bauelement gesintert werden.

Während des Sintervorgangs weisen die Schichten des Vielschichtbauelements unterschiedliche Sinterschwundeigenschaften auf. Somit ziehen sie sich während des Sintervorgangs in unterschiedlichem Maße zusammen. Das bedeutet, das über einen Sinterzeitraum ST, bei der beispielsweise eine konstante Temperatur Temp0 eingehalten wird, sich die Schichten unterschiedlich schnell zusammenziehen, sodass bereits hierdurch mechanische Spannungen entstehen können. Wird dagegen über einen Sinterzeitraum ST die Temperatur verändert, kann dieser Prozess noch weiter moduliert werden.

Beispielsweise könnte bei einer Temperatur Temp1 in einem Zeitfenster ST_{t1 + δt} innerhalb des Zeitfensters ST eine erste Schicht x% ihres Vorsintervolumens verlieren, dagegen eine zweite benachbarte Schicht y% ihres Vorsintervolumens. Innerhalb eines späteren Zeitraums ST_{t2 + δt} könnte bei einer anderen Temperatur Temp2 die erste Schicht u% ihres Vorsintervolumens verlieren, die zweite benachbarte Schicht dagegen w% ihres Vorsintervolumens.

Ingesamt werden die Temperaturen, denen das Vielschichtbauelement ausgesetzt ist, derart über einen Sinterzeitraum gesteuert, dass vorzugsweise jede Schicht im gesinterten und abgekühlten Zustand des Vielschichtbauelements in ihre gewünschte Form gelangt ist, unabhängig davon, auf welchem Wege sie dieses erreicht. Insbesondere sind die Formen bzw. lateralen Ausmaße der Schichten des Stapels im Endzustand derart miteinander vergleichbar, dass ein Vielschichtbauelement entsteht, welches möglichst ebene Außenflächen aufweist. Im Falle von rechteckigen Schichten sollte dabei beispielsweise ein quaderförmiger Stapel mit ebenen Seitenflächen entstehen.

Die beschriebenen Gegenstände werden anhand der folgenden Figuren und Ausführungsbeispiele näher erläutert. Dabei zeigt bzw. zeigen:
- Figur 1: ein piezoelektrisches Vielschichtbauelement,
- Figur 2: den Sinterschwund unterschiedlicher Keramikmischungen in Abhängigkeit von Temperatur,
- Figur 3: das geometrische Verhältnis benachbarter Schichten bei einer ersten Temperatur,
- Figur 4: das geometrische Verhältnis und das unterschiedliche Sinterschwundverhalten benachbarter Schichten bei einer zweiten Temperatur,
- Figur 5: das geometrische Verhältnis und das unterschiedliche Sinterschwundverhalten benachbarter Schichten bei einer zweiten Temperatur.

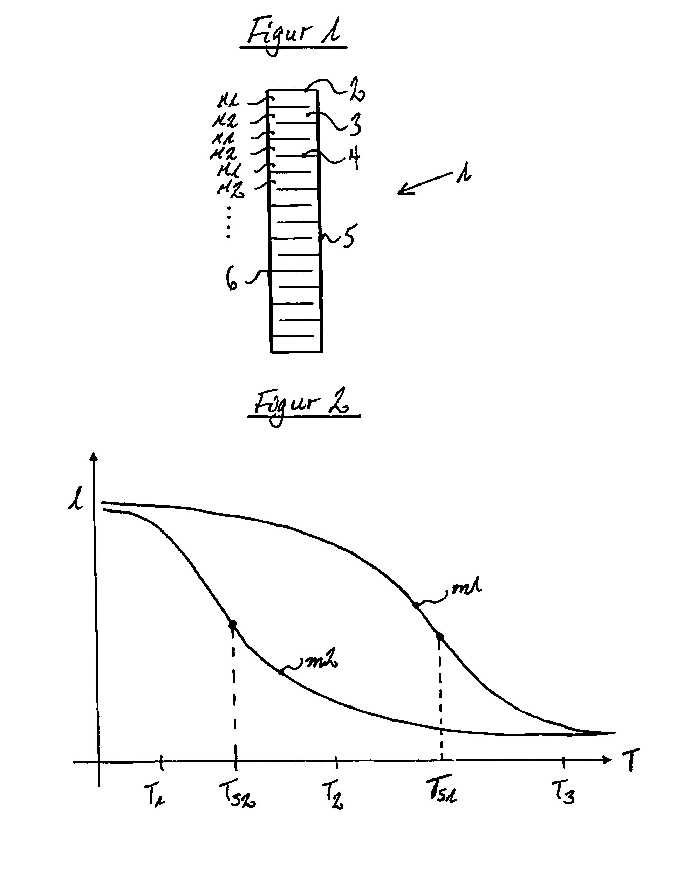

Figur 1 zeigt ein piezoelektrisches Vielschichtbauelement 1 mit einem Grundkörper 2, der einen Stapel von übereinander angeordneten piezokeramischen Schichten 3 und Elektrodenschichten 4 umfasst. An zwei Außenflächen des Grundkörpers 2 sind sich in Längsrichtung erstreckende elektrische Außenkontakte 5 und 6 aufgebracht, welche der elektrischen Kontaktierung des Bauelements dienen. Die Elektrodenschichten 3 können Kupfer, Palladium und / oder Silber bzw. eine Legierung aus mehreren dieser Materialien enthalten.

Benachbarte piezokeramische Schichten 3 weisen mittels unterschiedlicher Materialzusammensetzungen M1 und M2 unterschiedliche Sinterschwundeigenschaften auf. Es sind piezokeramische Schichten 3 abwechselnd, d.h. in der Reihenfolge M1, M2, M1, M2, mit unterschiedlichen Materialzusammensetzungen übereinander gestapelt. Es hat sich beispielsweise als günstig herausgestellt, wenn die Materialzusammensetzungen benachbarter piezokeramischer Schichten derart gewählt werden, dass deren Kalzinationstemperaturen sich um zwischen 120 bis 80 C, insbesondere um etwa 100 C, unterscheiden. Zusätzlich oder alternativ könnten sich die Korngrößen bzw. Durchmesser der piezokeramischen Körner benachbarter Schichten um zwischen 1,1 bis 1,6 µm unterscheiden, wobei dennoch jede Schicht eine eigene Korngrößenverteilung mit einer Varianz von wenigen Zehntel µm aufweisen könnte. Beispielsweise könnten die Körner einer Schicht M1 Durchmesser zwischen 0,4 und 0,6 µm aufweisen und die Körner einer benachbarten Schicht M2 Durchmesser zwischen 1,5 und 2,2 µm aufweisen. Eine Schicht M2 kann eine Korngrößenverteilung mit größeren Körnern aufweisen, als eine ihr benachbarten Schicht M1.

Figur 2 zeigt eine Grafik mit zwei Kurven m1 und m2, welche jeweils die temperaturabhängige Sinterschwundeigenschaft von piezokeramischen Schichten 3 mit einer Materialzusammensetzung M1 bzw. M2 darstellt. Die Kurve m1 zeigt wie die laterale Abmessung 1 einer piezokeramischen Schicht 3 mit Materialzusammensetzung M1 in Abhängigkeit zunehmender Temperatur abnimmt. Bei einer Temperatur T₁ beginnt der Sinterschwundprozess und es wird ein maximaler Sinterschwund der piezokeramischen Schicht 3 mit der Materialzusammensetzung M1 bei Temperatur T_{S2} erreicht. Bei dieser Temperatur erreicht die Änderung der lateralen Abmessung 1 im Verhältnis zum Temperatur ihren Höhepunkt. Danach verringert sich die laterale Abmessung der piezokeramischen Schicht weiter, bis bei einer Temperatur T₃ fast keine Änderung der lateralen Abmessung mehr zu verzeichnen ist.

Die Kurve m2 zeigt wie die laterale Abmessung 1 einer piezokeramischen Schicht 3 mit Materialzusammensetzung M2 in Abhängigkeit zunehmender Temperatur abnimmt. Bei Temperatur T₁ beginnt der Sinterschwundprozess und es wird ein maximaler Sinterschwund der piezokeramischen Schicht 3 mit der Materialzusammensetzung M2 bei Temperatur T_{S1} erreicht. Bei der maximalen Sintertemperatur erreicht die Änderung der lateralen Abmessung 1 im Verhältnis zur Temperatur ihren Höhepunkt. Danach verringert sich die laterale Abmessung der piezokeramischen Schicht zwar weiter, jedoch weniger schnell. Bei einer Temperatur T₃ ist keine oder zumindest fast keine Änderung der lateralen Abmessung mehr zu verzeichnen.

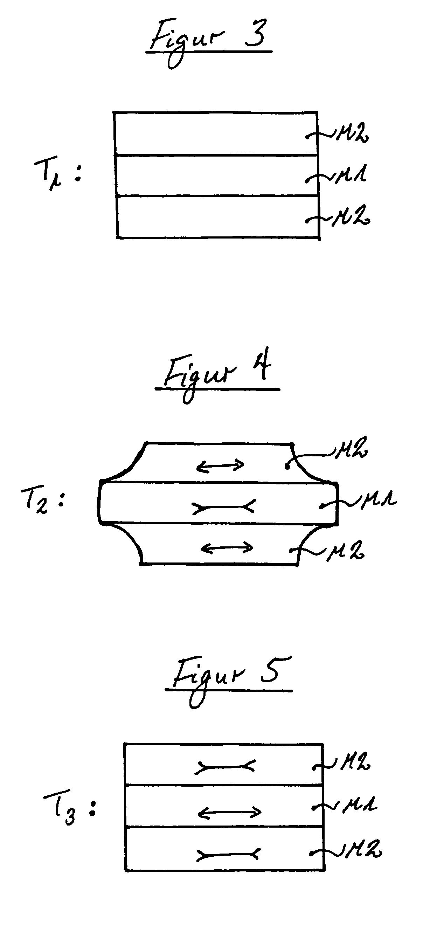

Figur 3 zeigt einen Stapel von schematisch dargestellten 3 piezokeramischen Schichten vor einem Sintervorgang. Die oberste Schicht und die unterste Schicht gemäß der Darstellung weisen dieselbe Materialzusammensetzungen M2 auf. Eine zwischen diesen Schichten angeordnete piezokeramische Schicht weist eine andere Materialzusammensetzung M1 auf, die sich in ihren Sinterschwundeigenschaften von derjenigen der benachbarten Schichten unterscheidet. Die Darstellung gibt den Zustand der Schichten an, wenn sie nicht einer zu einem Sinterschwund führenden Temperatur T₁ ausgesetzt sind.

Figur 4 zeigt den Stapel von Figur 3 bei einer anderen Temperatur T₂ (siehe hierzu auch Figur 2), wobei die Schichten mit den Materialzusammensetzungen M2 einen höheren Sinterschwund aufweisen, als die zwischen ihnen liegende Schicht mit der Materialzusammensetzung M1. Daher werden die Schichten M2 mit einer geringeren lateralen Abmessung gezeigt, als bei der Schicht M1. Die in den Schichten jeweils gezeigten Pfeile deuten auf Zug- bzw. Druckbelastungen. Aufgrund des langsameren Sinterschwunds der mittleren Schicht M1 im Vergleich zu ihren angrenzenden Schichten wirkt eine Zugkraft auf die angrenzenden Schichten mit Materialzusammensetzung M2. Diese wird mit nach außen zeigenden Pfeilen gezeigt. Das Gegenteil gilt für die mittlere Schicht: aufgrund des höheren Sinterschwunds ihrer angrenzenden Schichten wird die mittlere Schicht M1 durch sie mitgezogen bzw. es wirkt eine nach Innen wirkende Druckkraft auf die mittlere Schicht.

Die durch das unterschiedliche Sinterverhalten benachbarter Schichten verursachten mechanischen Spannungen führen zu mechanisch weniger stabilen Grenzbereichen zwischen den Schichten.

Figur 5 zeigt den Stapel von Figuren 3 und 4 bei einer anderen Temperatur T₃ (siehe hierzu auch Figur 2), wobei bis zu diesem Zeitpunkt bereits ein im Vergleich zur Figur 4 umgekehrter Effekt eingetreten ist. Seit dem Aussetzen des Stapels der vorhergehenden Temperatur T₂ bis einschließlich der Temperatur T₃ weisen die Schichten mit den Materialzusammensetzungen M2 einen geringeren Sinterschwund auf, als die zwischen ihnen liegende Schicht mit der Materialzusammensetzung M1. Aufgrund des schnelleren Sinterschwunds der mittleren Schicht M1 im Vergleich zu ihren angrenzenden Schichten wirkt eine Druckkraft auf die angrenzenden Schichten mit Materialzusammensetzung M2. Diese wird mit nach Innen zeigenden Pfeilen gezeigt. Das Gegenteil gilt für die mittlere Schicht: aufgrund des langsameren Sinterschwunds ihrer angrenzenden Schichten wird die mittlere Schicht M1 in ihr Bestreben, sich nach innen zu ziehen, durch die ihr angrenzenden Schicht gebremst bzw. es wirkt eine nach Außen wirkende Druckkraft auf die mittlere Schicht M1.

Bis zu einer Temperatur T₃ wie oben erläutert haben die gegenseitigen Auswirkungen der unterschiedlichen lateralen Kontraktionen der Schichten dazu geführt, dass ein von seiner Außenfläche ebener Stapel, d.h. ein Stapel mit einem sich über die Höhe des Stapels erstreckenden, einheitlichen Umriss, geschaffen wird. Bis zu diesem Zeitpunkt sind jedoch materialgeschwächte Grenzflächen bzw. Grenzbereiche zwischen den einzelnen Schichten des Piezoaktors entstanden, die eine kontrollierte, parallel zu den Schichten verlaufende Rissbildung im Falle bestimmter Zugbelastungen eines in Betrieb genommenen Piezoaktors erlauben.

### Bezugszeichenliste

- 1: piezoelektrisches Bauelement
- 2: Grundkörper
- 3: piezokeramische Schicht
- 4: Elektrodenschicht
- 5: erster Außenkontakt
- 6: zweiter Außenkontakt

- T1 bis T3: unterschiedliche Temperaturen

- M1: erste Materialzusammensetzung
- M2: zweite Materialzusammensetzung
- m1: Sinterschwundverhalten der ersten Materialzusammensetzung
- m2: Sinterschwundverhalten der zweiten Materialzusammensetzung

## Patentansprüche

1. Piezoelektrisches Vielschichtbauelement (1), umfassend einen Grundkörper (2) mit einem Stapel von abwechselnd übereinander angeordneten piezokeramischen Schichten (3) und Elektrodenschichten (4), bei dem eine piezokeramische Schicht (3), die zwischen zwei weiteren piezokeramischen Schichten (3) angeordnet ist, gegen diese Schichten (3) verspannt ist , wobei die Spannungen senkrecht zur Stapelrichtung verlaufen.

2. Piezoelektrisches Vielschichtbauelement nach Anspruch 1, bei dem die benachbarten Schichten (3, 4) unter gegenseitiger Zugspannung stehen.

3. Piezoelektrisches Vielschichtbauelement nach einem der vorhergehenden Ansprüche, bei dem benachbarte Schichten (3, 4) des Stapels unterschiedliche Sinterschwundeigenschaften aufweisen.

4. Piezoelektrisches Vielschichtbauelement (1) nach einem der vorhergehenden Ansprüche, bei dem benachbarte Schichten (3, 4) unterschiedliche keramische Korngrößenverteilungen aufweisen.

5. Piezoelektrisches Vielschichtbauelement (1) nach einem der vorhergehenden Ansprüche, das möglichst ebene Außenflächen aufweist.

6. Piezoelektrisches Vielschichtbauelement (1) nach einem der vorhergehenden Ansprüche, bei dem die Materialien benachbarter piezokeramischer Schichten (3) verschiedene Kalzinationstemperaturen aufweisen.

7. Piezoelektrisches Vielschichtbauelement nach Anspruch 6, bei dem sich die Kalzinationstemperaturen der Materialien benachbarter piezokeramischer Schichten (3) um zwischen 80 bis 120 C unterscheiden.

8. Piezoelektrisches Vielschichtbauelement (1) nach einem der vorhergehenden Ansprüche, bei dem die benachbarten Schichten (3, 4) unterschiedliche Dotierstoffe (3, 4) enthalten, welche die relative mechanische Spannung zwischen ihnen beeinflussen.

9. Piezoelektrisches Vielschichtbauelement (1) nach einem der Ansprüche 3 bis 8, bei dem die benachbarten Schichten (3, 4) unterschiedliche Dotierstoffe (3, 4) enthalten, welche ihre jeweiligen Sinterschwundeigenschaft beeinflussen.

10. Piezoelektrisches Vielschichtbauelement (1) nach einem der vorhergehenden Ansprüche, bei dem benachbarte Schichten (3, 4) unterschiedliche Sinterhilfmittel enthalten.

11. Verfahren zur Herstellung eines piezoelektrischen Vielschichtbauelements, bei dem
- unterschiedliche piezokeramische Mischungen mit Keramikkörnern unterschiedlicher Größen bereitgestellt werden,
- den unterschiedlichen piezokeramischen Mischungen jeweils Bindemittel beigemengt wird,
- die unterschiedlichen piezokeramischen Mischungen zu unterschiedlichen Grünfolien verarbeitet werden,
- die Grünfolien mit Elektrodenschichten bedruckt werden,
- die mit Elektrodenschichten bedruckten Grünfolien zurechtgeschnitten und derart zu einem Stapel übereinander gestapelt werden, dass benachbarte Schichten des Stapels unterschiedliche Korngrößenverteilungen aufweisen,
- der Stapel entbindert und anschließend zu einem monolithischen Bauelement gesintert wird, wobei
- während des Sinterns die Schichten des Stapels unterschiedliche Sinterschwünde erfahren.

12. Verfahren nach Anspruch 11, bei dem die Temperaturen, denen der Stapel während des Sinterns ausgesetzt ist, derart über einen Sinterzeitraum gesteuert werden, dass jede Schicht im gesinterten und abgekühlten Zustand des Stapels in eine Form gelangt ist, sodass die lateralen Maße der Schichten derart vergleichbar sind, dass ein Stapel entsteht, der möglichst ebene Außenflächen aufweist.

13. Verfahren nach einem der Ansprüche 11 oder 12, bei dem die Materialzusammensetzungen benachbarter piezokeramischer Schichten derart gewählt werden, dass sich deren Kalzinationstemperaturen zwischen 80 und 120 °C unterscheiden.

14. Verfahren nach einem der Ansprüche 11 bis 13, bei dem piezokeramische Mischungen derart bereitgestellt werden, dass sich die Korngrößen benachbarter piezokeramischer Schichten um zwischen 1,1 und 1,6 µm unterscheiden.

## Claims

1. Piezoelectric multi-layer component (1), comprising a base body (2) with a stack of piezoceramic layers (3) and electrode layers (4) arranged one on top of the other in an alternating manner, in which a piezoceramic layer (3), which is arranged between two further piezoceramic layers (3), is braced against these layers (3), the stresses running perpendicularly to the stacking direction.

2. Piezoelectric multi-layer component according to Claim 1, in which the neighboring layers (3, 4) are under tensile stress with respect to one another.

3. Piezoelectric multi-layer component according to one of the preceding claims, in which neighboring layers (3, 4) of the stack have different sintering shrinkage properties.

4. Piezoelectric multi-layer component (1) according to one of the preceding claims, in which neighboring layers (3, 4) have different ceramic grain size distributions.

5. Piezoelectric multi-layer component (1) according to one of the preceding claims, which has outer surfaces that are as planar as possible.

6. Piezoelectric multi-layer component (1) according to one of the preceding claims, in which the materials of neighboring piezoceramic layers (3) have different calcination temperatures.

7. Piezoelectric multi-layer component according to Claim 6, in which the calcination temperatures of the materials of neighboring piezoceramic layers (3) differ by between 80 and 120°C.

8. Piezoelectric multi-layer component (1) according to one of the preceding claims, in which the neighboring layers (3, 4) contain different dopants (3, 4), which influence the relative mechanical stress between them.

9. Piezoelectric multi-layer component (1) according to one of Claims 3 to 8, in which the neighboring layers (3, 4) contain different dopants (3, 4), which influence their respective sintering shrinkage property.

10. Piezoelectric multi-layer component (1) according to one of the preceding claims, in which neighboring layers (3, 4) contain different sintering aids.

11. Method for producing a piezoelectric multi-layer component, in which
- different piezoceramic mixtures with ceramic grains of different sizes are prepared,
- a binder is respectively admixed with the different piezoceramic mixtures,
- the different piezoceramic mixtures are processed into different green sheets,
- the green sheets are printed with electrode layers,
- the green sheets printed with electrode layers are cut to size and stacked one on top of the other to form a stack in such a way that neighboring layers of the stack have different grain size distributions,
- the stack is debinded and subsequently sintered to form a monolithic component, wherein,
- during the sintering, the layers of the stack undergo different sintering shrinkages.

12. Method according to Claim 11, in which the temperatures to which the stack is exposed during the sintering are controlled over a sintering time period in such a way that each layer has reached a form in the sintered and cooled state of the stack such that the lateral extents of the layers are comparable in such a way that a stack which has outer surfaces that are as planar as possible is produced.

13. Method according to either of Claims 11 and 12, in which the material compositions of neighboring piezoceramic layers are chosen such that their calcination temperatures differ by between 80 and 120°C.

14. Method according to one of Claims 11 to 13, in which piezoceramic mixtures are prepared such that the grain sizes of neighboring piezoceramic layers differ by between 1.1 and 1.6 µm.

## Revendications

1. Composant à plusieurs couches piézoélectrique (1) comportant un corps de base (2) muni d'une pile de couches piézocéramiques (3) et de couches d'électrode (4) disposées en alternance les unes au-dessus des autres, dans lequel une couche piézocéramique (3), laquelle est disposée entre deux autres couches piézocéramiques (3), est contractée contre ces couches (3), les contraintes se propageant perpendiculairement au sens de la pile.

2. Composant à plusieurs couches piézoélectrique selon la revendication 1, dans lequel les couches voisines (3, 4) sont sous une contrainte de traction réciproque.

3. Composant à plusieurs couches piézoélectrique selon l'une des revendications précédentes, dans lequel les couches voisines (3, 4) de la pile présentent des caractéristiques d'affaiblissement de frittage différentes.

4. Composant à plusieurs couches piézoélectrique (1) selon l'une des revendications précédentes, dans lequel les couches voisines (3, 4) présentent des distributions de granulométrie céramique différentes.

5. Composant à plusieurs couches piézoélectrique (1) selon l'une des revendications précédentes, lequel présente des surfaces extérieures si possible planes.

6. Composant à plusieurs couches piézoélectrique (1) selon l'une des revendications précédentes, dans lequel les matériaux des couches piézocéramiques (3) voisines présentent des températures de calcination différentes.

7. Composant à plusieurs couches piézoélectrique selon la revendication 6, dans lequel les températures de calcination des matériaux des couches piézocéramiques (3) voisines présentent une différence entre 80 et 120 °C.

8. Composant à plusieurs couches piézoélectrique (1) selon l'une des revendications précédentes, dans lequel les couches voisines (3, 4) contiennent des matériaux de dopage (3, 4) différents qui influencent la contrainte mécanique relative entre elles.

9. Composant à plusieurs couches piézoélectrique (1) selon l'une des revendications 3 à 8, dans lequel les couches voisines (3, 4) contiennent des matériaux de dopage (3, 4) différents qui influencent leur caractéristique d'affaiblissement de frittage respective.

10. Composant à plusieurs couches piézoélectrique (1) selon l'une des revendications précédentes, dans lequel les couches voisines (3, 4) contiennent des auxiliaires de frittage différents.

11. Procédé de fabrication d'un composant à plusieurs couches piézoélectrique, selon lequel
- des mélanges piézocéramiques différents avec des grains de céramique de différentes tailles sont fournis,
- des liants sont respectivement additionnés aux différents mélanges piézocéramiques,
- les différents mélanges piézocéramiques sont traités pour obtenir différents films verts,
- des couches d'électrode sont imprimées sur les films verts,
- les films verts sur lesquels sont imprimées les couches d'électrode sont débités et empilés les uns au-dessus des autres en une pile de telle sorte que les couches voisines de la pile présentent des distributions de granulométrie céramique différentes,
- la pile est déliée et ensuite frittée en un composant monolithique,
- les couches de la pile subissant différents affaiblissements de frittage pendant le frittage.

12. Procédé selon la revendication 11, selon lequel les températures auxquelles est exposée la pile pendant le frittage sont commandées sur une période de frittage de telle sorte que chaque couche, à l'état fritté et refroidi de la pile, parvient à une forme de telle sorte que les cotes latérales des couches sont comparables, de manière à ce qu'il se produise une pile qui présente des surfaces extérieures si possible planes.

13. Procédé selon l'une des revendications 11 ou 12, selon lequel les compositions de matériau des couches piézocéramiques voisines sont choisies de telle sorte que leurs températures de calcination présentent une différence entre 80 et 120 °C.

14. Procédé selon l'une des revendications 11 à 13, selon lequel les mélanges piézocéramiques sont fournis de telle sorte que les granulométries des couches piézocéramiques voisines présentent une différence entre 1,1 et 1,6 µm.
